# EUROPEAN PATENT SPECIFICATION

(11) **EP 4 336 138 B1**
(45) Date of publication and mention of the grant of the patent: **21.10.2026**
(21) Application number: 23192364.0
(22) Date of filing: 21.08.2023
(51) Int. Cl.: G01B 9/02, G01B 9/02056, G01B 9/02055, G01B 11/24, G01M 11/02

(54) **INTERFEROMETRIC MEASUREMENT METHOD AND INTERFEROMETRIC MEASUREMENT SYSTEM**
INTERFEROMETRISCHES MESSVERFAHREN UND INTERFEROMETRISCHES MESSSYSTEM
PROCÉDÉ DE MESURE INTERFÉROMÉTRIQUE ET SYSTÈME DE MESURE INTERFÉROMÉTRIQUE

(30) Priority: 12.09.2022 DE 102022209477
(43) Date of publication of application: 13.03.2024
(73) Proprietor: Carl Zeiss SMT GmbH, 73447 Oberkochen (DE)
(72) Inventor: Doerband, Bernd, 73434 Aalen (DE)
(74) Representative: Patentanwälte Ruff, Wilhelm, Beier, Dauster & Partner mbB

(56) References cited:
- DE-A1- 102015 222 789

## Description

### FIELD OF APPLICATION AND PRIOR ART

The following disclosure is based on German Patent Application No. 10 2022 209 477.8 filed on September 12, 2022.

The invention relates to a measurement method and to a measurement system for interferometrically determining a shape of an optical surface of a test object.

One general field of application is the high-precision interferometric measurement of optical surfaces and optically transparent objects. One specific field of application is ultrahigh-precision interferometric measurement, such as is used e.g. during the production of lithographic projection optical units. That involves measurement uncertainties of less than 1/100 of the visible wavelength.

Freeform surface mirrors or freeform lenses are increasingly being used in lithographic projection optical units. The rotary imparting method that can be applied to rotationally symmetrical aspheres is dispensed with in the interferometric testing of freeform surfaces owing to the asymmetry of the test object. Since the traditional calibration with rotary imparting of rotationally asymmetrical aberrations is not possible, an optical disturbance signal (speckle effects) remains which is produced inter alia by the surface fine structure of the interferometer components.

One traditional means of minimizing or avoiding the coherent disturbances and artefacts caused by interferometer components is the use of a large light source. The latter ensures that fine structures on the components are imaged blurred, such that their coherent disturbing effects are damped. Large light sources can be used e.g. in two-beam interferometers of the "Michelson" or "Twyman-Green" type. Such types of interferometers are used rather rarely, however, owing to various constraints.

The workhorse in the optics workshop, especially in the production of elements of lithographic projection optical units, is the "Fizeau" type of interferometer (Fizeau interferometer). A measurement system with a Fizeau interferometer comprises an illumination module which produces an effective light source. Light emitted by the illumination module is collimated by a collimator. A beam splitter is situated between the illumination module and the collimator. The collimated beam passes through a transparent reference element, the exit surface of which, manufactured with high optical quality, serves as a reference surface which reflects part of the light. The transmitted portion continues to propagate to the surface of the test object. The space between reference surface and surface of the test object is referred to as a cavity of the interferometer. The portion reflected by the surface of the test object contains information about the aberration caused by the test object. The wavefronts of both portions interfere in the interferometer and are guided via the beam splitter onto the sensor surface of a detector. A sharp image of the sample surface arises on the sensor surface, said image being pervaded with a stripe pattern (the interference pattern). In this case, a continuous stripe indicates regions with an identical air gap thickness. By contrast, adjacent stripes indicate a change in thickness corresponding to half the wavelength of the light.

According to the rules of spatial coherence, the size of the light source must not exceed a specific size in order that interference images with sufficient contrast result.

It has already been proposed to reduce coherent disturbances by using a circular light source (DE 10 121 516 A1 corresponding to US 2003/0030819 A1) or an arcuate light source (DE 10 2016 213 237 A1 corresponding to US 2019/0154427 A1).

Another solution proposal provides a movable punctiform light source with temporally sequential recording and computation of the phase images (cf. e.g. US 2012/0236316 A1).

DE 10 2015 222 789 A1 describes a solution in which the illumination module has an additional module in the form of an upstream interferometer with an upstream cavity.

### PROBLEM AND SOLUTION

Against this background, the invention addresses the problem of reducing the influence of coherent disturbances on the measurement accuracy of interferometric measurements, without having to implement limitations in the design of light sources.

In order to solve this problem, the invention provides a measurement method having the features of Claim 1. Furthermore, a measurement system having the features of Claim 6 is provided. Preferred developments are specified in the dependent claims. The wording of all the claims is incorporated by reference in the content of the description.

The measurement method can be carried out by any conventional measurement system which has the features of the preamble of Claim 1. Special features reside in the manner of the evaluation and optionally the use of the measurement system. Interferometer surfaces are identified in the method. An interferometer surface is an optically effective surface of one of the optical components of the measurement system. Surface-related coherent wavefront disturbances are determined during the evaluation. Each of the wavefront disturbances is assigned to corresponding disturbing structures on one of the interferometer surfaces. The evaluation comprises a surface-specific subtraction of the surface-related coherent wavefront disturbances from the measured wavefront. A wavefront corrected in respect of coherent wavefront disturbances is ascertained as a result. This corrected wavefront can then be evaluated. Since coherent wavefront disturbances are then no longer present in the wavefront on which the evaluation is based, said wavefront represents with a better signal/noise ratio that sought wavefront which permits conclusions to be drawn from about the surface shape.

The measurement method proposed here does not require additional apparatus extensions of a conventional measurement system. Instead, a measurement method is provided in which the measured wavefront is computationally corrected in respect of coherent disturbances. In this case, it is e.g. unimportant whether use is made of a punctiform light source or an extensive light source whose size is limited by physically governed limitations.

In accordance with one formulation, in essence the claimed invention thus provides for localizing and quantifying the coherent disturbances originating from individual interferometer surfaces, in order subsequently to subtract their effect from the measurement result. In contrast to the prior art, damping or averaging of unknown disturbances is not striven for here. A determination of origin, position and size of the individual disturbances is carried out instead.

The term "coherent disturbance" can be understood as follows. A dust grain (as an example) on an arbitrary interferometer surface is generally not imaged sharply onto the camera (detector). Upon illumination, a "spherical wave" that is coherent with respect to the illuminating wave emanates from said dust grain. In the detector surface or on the camera, the "spherical wave" and the illuminating wave interfere and form a fine ring pattern. The latter is referred to as "coherent disturbance". When an extensive light source is used, each point of the light source forms a separate "coherent disturbance". Since each light source point is incoherent with respect to its neighbouring point, the "coherent disturbances" of each point add up incoherently on the camera. The ring patterns of all the points become blurred.

In this application, the term "individual disturbance" denotes the coherent disturbances originating from an individual image of an individual interferometer surface.

In accordance with one development, a computational propagation of the ascertained wavefront according to amplitude and phase is carried out. This has the effect that the surface-related disturbing structures of optically effective surfaces appear sharp in each case. These disturbing structures are then eliminated from amplitude and phase of the respective focused interferometer surface images. A backpropagation is then carried out, whereby a corrected wavefront is ascertained which no longer contains wavefront disturbances caused by the disturbing structures.

During computational "focusing (propagation)" of the measured wavefront according to amplitude and phase, the fine ring pattern of the coherent disturbance becomes a sharp image of the dust grain. That can then be removed computationally (e.g. by means of median filters). The corrected wavefront is obtained after backpropagation.

In order to provide the bases for the correction, according to the claimed invention a calibration measurement is carried out in which a quasi-punctiform effective light source is used. The individual corrections of the wavefront that originate from the interferometer surface images are determined on the basis of the results of the calibration measurement. A regular measurement is then carried out with the aid of an extensive effective light source whose relative brightness distribution is known. By computationally adapting the individual corrections of the wavefront to the known extensive effective light source, an overall wavefront correction can be ascertained. The latter is then subtracted from the measured wavefront to leave a corrected wavefront.

The overall wavefront correction for the measurement with an extensive effective light source can be carried out by means of a computation of correction values ascertained with a punctiform effective light source with the aid of a convolution function representing the blurring effect of the extensive light source.

The invention also relates to a measurement system for interferometrically determining a shape of an optical surface of a test object. The measurement system is configured for carrying out the measurement method. For this purpose, an evaluation unit is provided, inter alia, which has software loaded which enables the evaluation unit to carry out the calculations explained.

### BRIEF DESCRIPTION OF THE DRAWINGS

Further advantages and aspects of the invention are evident from the claims and from the description of exemplary embodiments of the invention, which will be explained below with reference to the figures.
Figure 1 schematically shows a measurement system with a Fizeau interferometer;
Figure 2 shows examples of coherent disturbances as a result of small particles on different optical surfaces of an interferometer in an intensity image (Figure 2A) and in the wavefront (Figure 2B);
Figure 3 shows an example of the three imagings of a collimator surface relative to the CCD camera surface;
Figure 4 shows an example of convolution kernels for amplitude and phase;
Figure 5 shows, in Figure 5A, an example of measured intensity A'²(x,y) for amplitude artefacts on an interferometer surface and, in Figure 5B, an example of refocused intensity A"²(x,y) for amplitude artefacts on an interferometer surface;
Figure 6 shows, in Figure 6A, a measured phase *ϕ*'(*x, y*) · *λ*/2*π* in nm for the example from Figure 5A and, in Figure 6B, the calculated phase ϕ"(x,y)·λ/2π in nm for the example from Figure 5B;
Figure 7 shows, in Figures 7A to 7D, an example of the processing of a wavefront which is measured with a small light source and which is covered by diffraction rings caused by punctiform particles on an interferometer surface;
Figure 8 shows, in Figures 8A to 8D, the corresponding effects on the amplitude;
Figure 9 shows the beam path of light source marginal rays in the eyepiece region in the case of Figure 3 with small dust grains on surface 4 in Figure 1;
Figure 10 shows, in Figure 10A, an example of a wavefront and, in Figure 10B, an example of the amplitude, which were measured with a large light source, corresponding data sets with a small light source being indicated in association with Figures 7A and 8A.

### DETAILED DESCRIPTION OF THE EXEMPLARY EMBODIMENTS

Hereinafter, theoretical principles of the invention will be explained and possibilities for practical implementation will be illustrated on the basis of exemplary embodiments.

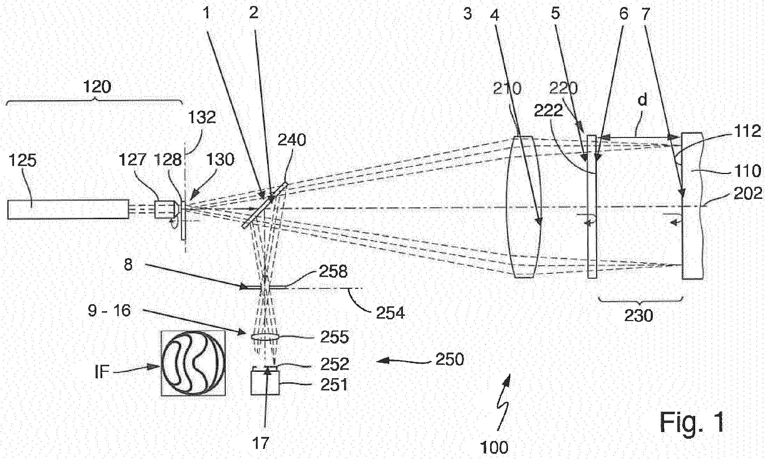

Figure 1 schematically shows a measurement system 100 from the prior art with a Fizeau interferometer for interferometrically determining the shape of an optical surface 112 of a test object 110 held in a test object holder (not illustrated)
The measurement system 100 comprises an illumination module 120 comprising a primary light source 125, which generates measurement light having a measurement wavelength in the visible wavelength range, e.g. at a wavelength of approximately 532 nm, during operation. Optical elements of the illumination module serve for receiving the measurement light and for producing an extensive effective light source 130 in a light source plane 132 of the illumination module.

In the example in Figure 1, a laser is used as the primary light source 125. A beam expanding optical unit 127 disposed downstream generates an expanded laser beam, which is incident on a rotating diffusing plate 128, where it forms a secondary light source in the form of a uniformly illuminated illumination spot having the desired size. This illumination spot, i.e. the secondary light source, functions as an effective light source 130 of the illumination module and emits measurement light in the direction of a collimator 210 or a collimation optical unit 210, which is among the optical components of the interferometer.

The collimator is a collimation optical unit 210 comprising one or more converging lenses, which serves for collimating the measurement light emitted by the effective light source 130 of the illumination module. A transparent reference element 220 is situated at a distance behind the collimator 210 in the parallelized beam path. The reference element 220 has a front optical surface facing the collimator and a back optical surface 222, which faces the surface 112 of the test object 110 and which serves as a reference surface 222 for the measurement. A cavity 230 is formed between the reference surface 222 and the surface 112 of the test object 110; the distance between the surface 112 of the test object and the reference surface 222 is the cavity length d.

A beam splitter 240 in the form of a plane-parallel partly transmissive plane plate is arranged obliquely in the beam path between the illumination module 120 and the collimator 210. Measurement light arriving from the illumination module 120 or from the effective light source 130 can pass through to the collimator. Measurement light reflected by the reference surface 222 and measurement light reflected by the surface 112 of the test object 110 are superimposed, impinge on the beam splitter 240 from the side facing the collimator and are reflected in a superimposed manner in the direction of a detector 250. The detector 250 comprises a CCD camera 251 comprising a planar sensor surface 252 or detector surface 252 and comprising a camera optical unit 255 disposed upstream. The arrangement is implemented such that light source images of the effective light source arise at a distance upstream of the camera in an intermediate image plane 254, and are imaged onto the sensor surface 252 by means of the camera optical unit. An interferogram IF with interference stripes arises there. A stop 258 is arranged in the intermediate image plane 254.

The inventor has recognized certain fundamental limitations of such measurement systems from the prior art. These limitations will be explained firstly with reference to Figure 1. What is important, firstly, is primarily that the measurement light does not originate from a punctiform effective light source, but rather from an effective light source 130 having a certain extent or size in the light source plane, e.g. a diameter of the order of magnitude of one or more millimetres, depending on the focal length of the collimator, the cavity length and the wavelength.

According to the rules of spatial coherence, the size 2θ of the light source must not exceed a specific size if the intention is to generate interference images with sufficient contrast. Let parameter θ be the aperture angle at which half the effective light source appears from the collimator 210. The following then holds true: $cos θ > 1 - \frac{λ}{4 d}$ (1)

In practice that restricts the possibility of suppressing high- and medium-frequency measurement errors which arise as a result of disturbing structures on interferometer components (e.g. as a result of roughness and surface defects, contaminants, bubbles and striations, etc.).

These limitations can be overcome at least in part by using the teaching of the invention. The proposed method ascertains and reduces the disturbances originating from individual interferometer surfaces in the measured wavefront. This primarily involves punctiform and filamentary disturbances on the surfaces, e.g. small dust grains, scratches, damage. If appropriate, damping of unwanted reflection images of the light source can also be achieved.

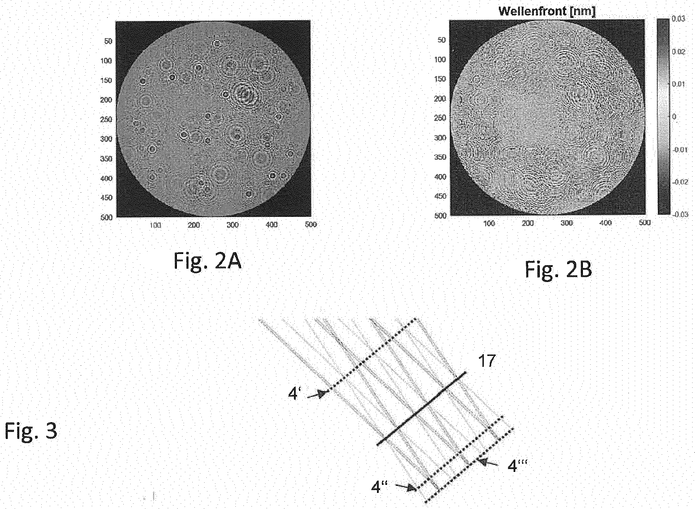

Figures 2A and 2B show examples of coherent disturbances as a result of small particles on different optical surfaces of an interferometer in an intensity image (Figure 2A on the left) and in the wavefront (Figure 2B on the right).

In the exemplary embodiment explained below, the method comprises a measurement sequence with a small (quasi-punctiform) light source (calibration measurement) for computationally determining the individual corrections originating from the individual surface images, the regular measurements with an arbitrarily shaped and extensive light source with a relative brightness distribution, a computational correction of the wavefront ascertained with an extensive light source, and a subtraction of the calculated overall correction from the measured wavefront. During the calibration measurement, a conventional wavefront ascertainment is performed using a quasi-punctiform light source. The result contains all coherent disturbances caused by every interferometer surface.

In one method variant, the method merely requires a calibration measurement with a small light source, which then provides the data sets required for the subsequent measurements with an arbitrarily extensive light source. As long as the beam path is not fundamentally changed and the artefacts on the surfaces remain unchanged, it is possible to use the data sets from the calibration measurement.

Hereinafter, the underlying theory will be explained and examples will be given.

Figure 1 indicates a Fizeau interferometer 100 by way of example, the optically effective surfaces (alternatively also referred to as "interferometer surfaces" in this application) of which are numbered using single- and double-digit numbers 1 to 17 in order to facilitate identification. These numbers are indicated in part in addition to the triple-digit reference signs. For each of the interferometer surfaces 1 to 16, by means of ray tracing, it is possible to calculate the image thereof after imaging through all the subsequent surfaces and to indicate the position and size relative to the camera plane or the detector plane 252 (corresponding to interferometer surface 17).

Consideration should be given to the multiple imagings of a surface by way of reflection at the reference surface and at the test object besides the directly observed image of the surface by means of the camera:
1) Surfaces which are observed after specular reflection at reference and test object and in addition directly by the camera (the surfaces 2, 3, 4 and 5 in Figure 1) have three (3) images.
2) Either such surfaces which have no direct image (surface 1) or the reference surface itself, which has only a direct image and specular reflection image at the test object, have/has two (2) images.
3) All eyepiece surfaces (surfaces 9 to 16) have one (1) image (direct imaging onto the camera).

Table 1 below indicates the numbers of the interferometer surfaces from Figure 1 and their number of images and coherent waves. In this case, the camera is set such that the test object (interferometer surface 7) is imaged sharply onto the camera surface or detector surface (interferometer surface 17). A differentiation between artefacts on the test object and the camera surface is then no longer possible.

The direct images during the return of the beams are coherently combined images since they arise as a result of illumination from the reference wave and the test object wave. Their interference structures are influenced by the cavity length d. Table 1 additionally indicates the number of coherent waves which lead to interference phenomena on the camera.

**Table 1**

| Surface | Designation | Number of images | Number of waves |
|---|---|---|---|
| 1 | Rear surface of splitter plate | 2 | 2 |
| 2 | Splitter surface | 3 | 4 |
| 3 | Collimator | 3 | 4 |
| 4 | Collimator | 3 | 4 |
| 5 | Rear surface of reference plate | 3 | 4 |
| 6 | Reference surface | 2 | 2 |
| 7 | Test object | 1 | 1 |
| 8 | Stop | 1 | 2 |
| 9 | Eyepiece surface | 1 | 2 |
| 10 | Eyepiece surface | 1 | 2 |
| 11 | Eyepiece surface | 1 | 2 |
| 12 | Eyepiece surface | 1 | 2 |
| 13 | Eyepiece surface | 1 | 2 |
| 14 | Eyepiece surface | 1 | 2 |
| 15 | Eyepiece surface | 1 | 2 |
| 16 | Eyepiece surface | 1 | 2 |
| 17 | Camera surface | 1 | 1 |

For explanation purposes, Figure 3 shows imagings of the collimator surface 4 relative to the CCD camera 17 for the Fizeau interferometer from Figure 1. In this case, the number 4' denotes the image of the surface 4 after reflection at the test object, the number 4" denotes the image of surface 4 after reflection at the reference surface, and the number 4‴ denotes the image of the surface upon direct imaging.

### Propagation methods

Two different variants are suitable for the propagation of a wavefront *O'*(*x, y*) measured in the camera plane into the image surface of a selected interferometer surface:
1) calculation in Fourier space,
2) calculation in real space.

More detailed explanations are given below. Let *O(x,y)* be the coherent disturbing wave to be determined that emanates from an interferometer surface $O \left(x, y\right) = A \left(x, y\right) {e}^{- iϕ \left(x, y\right)}$ (2) with *A*(*x, y*) as amplitude disturbance and *ϕ*(*x, y*) as phase disturbance. For imaging the disturbance onto the camera, *F(x,y)* is assumed as a point spread function. It describes the transfer function from the exit pupil of the eyepiece to the camera plane. The coherent wave *O'(x,y)* of the disturbance which impinges on the camera is then described by an unknown disturbing wavefront in accordance with $O ′ \left(x, y\right) = O \left(x, y\right) ∗ F \left(x, y\right) = A ′ \left(x, y\right) {e}^{- iϕ ′ \left(x, y\right)}$ (3) with "*" as convolution symbol. In Fourier space, (3) can be described as ${O ′}^{˜} \left(u, v, x, y\right) = {O}^{˜} \left(u, v\right) ⋅ {F}^{˜} \left(u, v, x, y\right) = {O}^{˜} \left(u, v\right) ⋅ P \left(u, v, x, y\right)$ (4) with "~" as the symbol for the Fourier transform. The Fourier transform of the point spread function *F(x,y)* is the pupil function *P*(*u,v,x,y*). It is dependent on the coordinates *u,v* in the Fourier plane (exit pupil of the eyepiece) and the respective object point *x,y* in the camera plane.

For the propagation of *O*'(*x, y*) into the image surface of a selected interferometer surface, (4) is multiplied by the complex defocus function ${O "}^{˜} \left(u, v, x, y\right) = {O ′}^{˜} \left(u, v, x, y\right) ⋅ {e}^{{iϕ}_{d} \left(u, v, x, y\right)}$ (5)

The defocus variable *ϕ_{d}*(*u*, *v, x, y*) is a function in *u,v* that is specific to each image point *x,y.* In the special case, it is identical for all *x,y.* For practical use, *ϕ_{d}* can be approximated by a quadratic function, e.g. ${ϕ}_{d} \left(u, v, x, y\right) = \frac{2 π}{λ} \left({d}_{1}u+{d}_{2}v+{d}_{3}{u}^{3}+{d}_{4 uv}+{d}_{5}{v}^{2}\right)$ (6) with *d*₁ to *d*₅ as coefficients for lateral offset, focus and astigmatism in the *u-* and v-directions. They result from the position of the relevant image surface (astigmatic image shells) with respect to the camera plane. An inverse Fourier transformation of (5) yields $O " \left(x, y\right) = O ′ \left(x, y\right) ∗ {FT}^{- 1} \left\{{e}^{{iϕ}_{d} \left(u, v, x, y\right)}\right\}$ (7) and hence the sought wave which propagated into the image shell, and which constitutes a sharpened disturbing wavefront, in accordance with $O " \left(x, y\right) = A " \left(x, y\right) {e}^{- iϕ " \left(x, y\right)}$ (8)

### "Sharpening" procedure

From the formalism described above, it is possible to describe two computational methods (see A) and B) below) for calculating the propagated ("sharpened") wave *O"*(*x, y*) from the measured wave *O'*(*x, y*). A prerequisite is the knowledge of a defocus variable *ϕ_{d}*(*u, v, x, y*), which is
a) either obtained from ray tracing or
b) iteratively varied until the coherent disturbances appear sharp.

### A) Defocusing in Fourier space

1. Determine amplitude *A'*(*x, y*) and phase *ϕ'*(*x, y*) in the camera plane from the interferometric measurement values,
2. Calculate complex field *O'*(*x, y*) *= A'*(*x, y*)*e*^{*-iϕ'*(*x*,*y*)},
3. Calculate Fourier transform ${O ′}^{˜} \left(u, v\right) = FT \left\{O′\left(x, y\right)\right\}$,
4. Multiply by defocus function ${O "}^{˜} \left(u, v\right) = {O ′}^{˜} \left(u, v\right) ⋅ {e}^{{iϕ}_{d} \left(u, v, x, y\right)}$,
5. Inverse Fourier transformation $O " \left(x, y\right) = {FT}^{- 1} \left\{{O "}^{˜}\left(u, v\right)\right\}$,
6. Calculate amplitude *A"*(*x, y*) *=* |*O"*(*x, y*)| and phase $ϕ " \left(x, y\right) = arctan \frac{Im \left(O"\left(x, y\right)\right)}{Re \left(O"\left(x, y\right)\right)}$

### B) Defocusing in Fourier space by convolution in real space

1. Determine amplitude *A'*(*x, y*) and phase *ϕ'*(*x, y*) in the camera plane from the interferometric measurement values,
2. Calculate complex field *O'*(*x, y*) *= A'*(*x, y*)*e*^{*-iϕ'*(*x,y*)},
3. Convolve with the Fourier transform of the defocus function $O " \left(x, y\right) = O ′ \left(x, y\right) ∗ {FT}^{- 1} \left\{{e}^{{iϕ}_{d} \left(u, v, x, y\right)}\right\} ,$
4. Calculate amplitude *A"*(*x, y*) *=* |*O"*(*x, y*)| and phase $ϕ " \left(x, y\right) = arctan \frac{Im \left(O"\left(x, y\right)\right)}{Re \left(O"\left(x, y\right)\right)}$

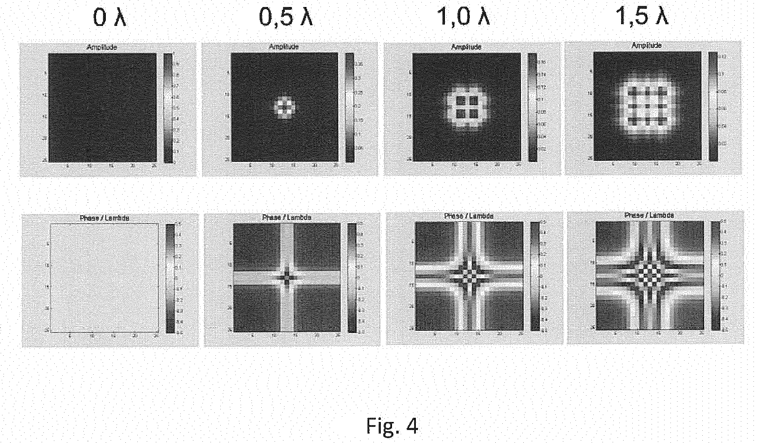

Figure 4 gives an example of convolution kernels for amplitude and phase according to the Fourier-transformed defocus function (point 3.) for various focus absolute values. This concerns convolution kernels (25 x 25 pixels) for propagating wavefronts for amplitude (upper row) and phase (lower row) for various focus absolute values in λ.

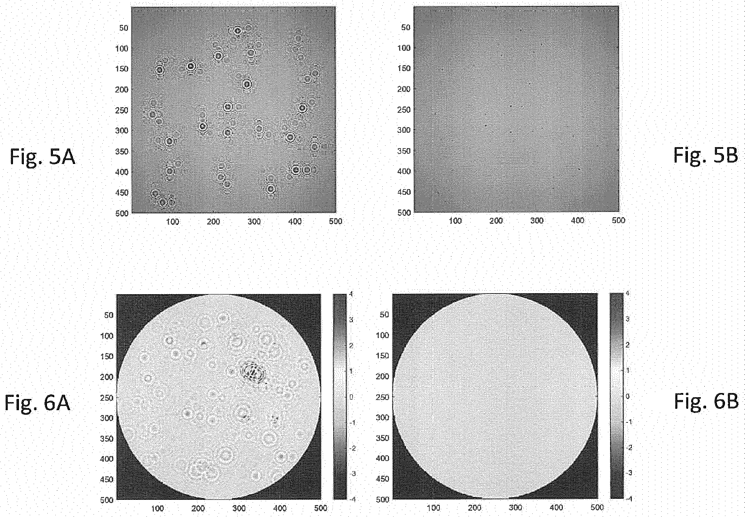

Figure 5A indicates an example of a brightness distribution *A'*²(*x, y*) in the camera plane, produced by punctiform amplitude disturbances (small dust grains) on an interferometer surface. Figure 5B shows the brightness distribution refocused computationally on the small dust grains. Figures 6A and 6B show the wavefronts in nm for the example from Figures 5A and 5B.

### Determining the coherent disturbances

The propagated wave ${O}_{k}^{"} \left(x, y\right)$ shows the sharpened image k of the coherent disturbances *Oₗ*(*x, y*) on an interferometer surface *I* during measurement with a small ("punctiform") light source. The disturbances are usually caused by dust particles or damage on the surface (scratches). The disturbing wave thus carries more or less extensive punctiform or linear modulations in amplitude and/or phase.

In order to eliminate same, tried and tested algorithms from image processing can be applied, for instance weighted median filters. In this case, a convolution operator is usually applied to the data fields of amplitude and phase.

After the filtering, the wave ${C}_{k}^{"} \left(x, y\right)$ corrected in respect of artefacts is present.

The corrected wave ${C}_{k}^{"} \left(x, y\right)$ is backpropagated → ${C}_{k}^{′} \left(x, y\right)$ into the camera plane. The correction wavefront ${δO}_{k}^{′} \left(x, y\right)$ results from the difference between measured wavefront and corrected wavefront: ${δO}_{k}^{′} \left(x, y\right) = {O}_{k}^{′} \left(x, y\right) - {C}_{k}^{′} \left(x, y\right)$ (9)

The procedure is repeated for all K images of interferometer surfaces until all coherent surface corrections ${δO}_{k}^{′} \left(x, y\right)$ are present (*k = 1* ... *K).*

### Procedure

The procedure for determining the surface artefacts measured in the camera plane arises as follows:
1. Determine amplitude *A'*(*x, y*) and phase *ϕ'*(*x, y*) in the camera plane from the interferometric measurement values with a small ("punctiform") light source,
2. Calculate complex field *O'*(*x, y*) *= A'*(*x, y*)*e*^{*-iϕ'*(*x,y*)},
3. *k* = 1 to *K* (*K* is the number of images of interferometer surfaces with disturbances)
   a. Propagate *O*'(*x, y*) into the *k-th* surface image ${O}_{k}^{"} \left(x, y\right)$,
   b. Remove coherent disturbances from amplitude image and phase image and calculate corrected wave ${C}_{k}^{"} \left(x, y\right)$,
   c. Backpropagate into camera plane: ${C}_{k}^{′} \left(x, y\right)$,
   d. Determine correction for surface k in camera plane ${δO}_{k}^{′} \left(x, y\right) = {O}_{k}^{′} \left(x, y\right) - {C}_{k}^{′} \left(x, y\right)$ (correction wavefront k),

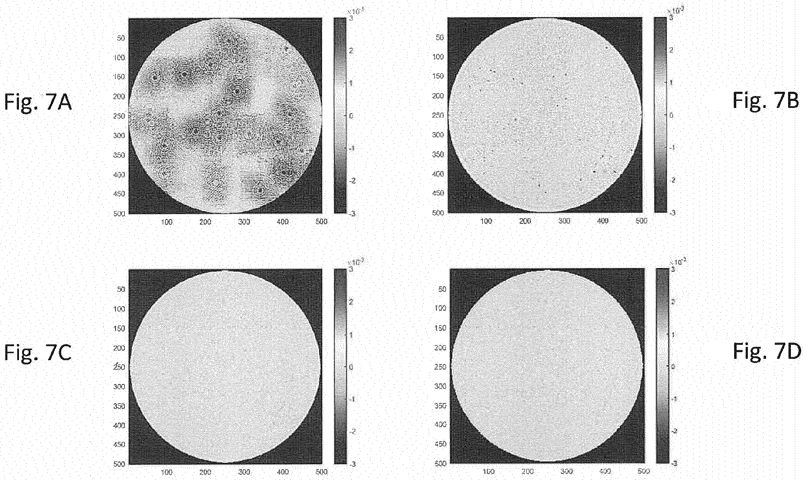

Figures 7A to 7D indicate an example of the processing of a wavefront which is measured with a small light source and which is covered by diffraction rings caused by punctiform particles on an interferometer surface. In this case, Figure 7A shows the measured wavefront, Figure 7B shows the defocused wavefront, Figure 7C shows the wavefront after filtering out the punctiform artefacts, and Figure 7D shows the corrected and back-focused wavefront.

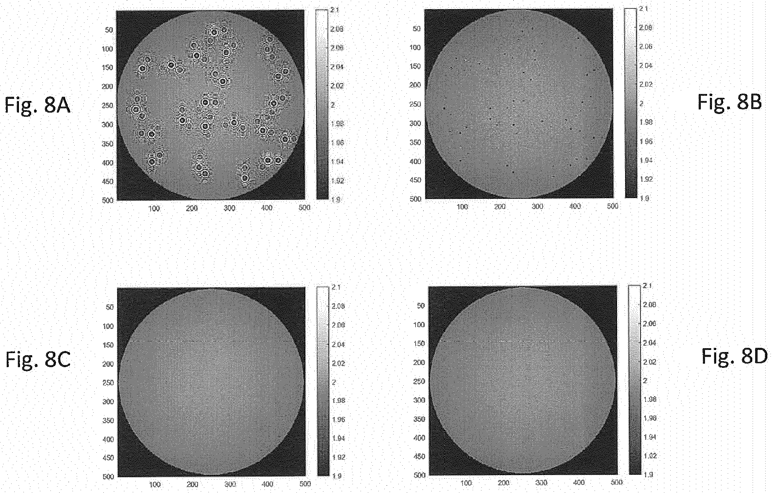

Figures 8A to 8D show the corresponding effects on the amplitude. Figure 8A shows the measured data fields, and Figure 8B shows the data fields defocused into the image shell of the causative surface. Figure 8C shows the data fields corrected in respect of the punctiform artefacts in Figure 8B. In Figure 8D, the corrected data fields are backpropagated into the camera plane.

### Measurement with an extensive light source

The surface artefacts are usually stationary artefacts which are imposed on the measured wavefront in the same way during all subsequent measurements.

If measurement is still carried out with a small light source, then the corrected wavefront *C'*(*x, y*) can be formed from the measured wavefront *O'*(*x, y*): $C ′ \left(x, y\right) = O ′ \left(x, y\right) - {\sum }_{k = 1}^{K} {δO}_{k}^{′} \left(x, y\right)$ (10)

Accordingly, the sum of the effects of the surface artefacts is subtracted.

With the use of an extensive light source, the corrections are no longer usable in this way. Instead, it is necessary to introduce a mathematical supplementation to transform the individual corrections ${δO}_{k}^{′} \left(x, y\right)$ in a suitable manner.

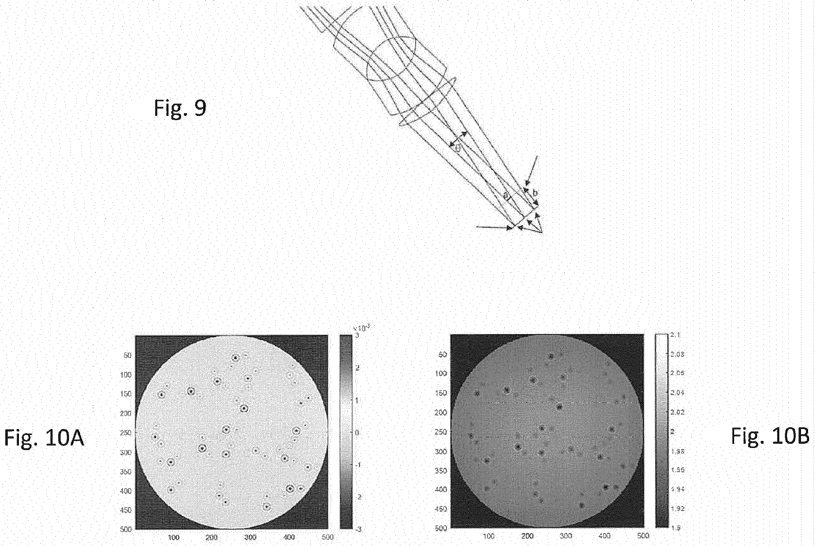

Figure 9 shows the beam path in the eyepiece camera region in the case of Figure 3 with punctiform disturbances on surface 4 in Figure 1. The illustration shows marginal rays of the light source which combine in the surface image k behind the camera plane. The following relationship holds true for the projection *aₖ*(*x, y*) of the brightness distribution *s(x, y)* in the light source image onto the camera plane: ${a}_{k} \left(x, y\right) = s \left(x, y\right) \frac{{b}_{k}}{{f}_{Ok}}$ (11) with
- *bₖ*: distance between the surface image shell k and the camera plane,
- *f_{Ok}*: focal length of the eyepiece,
- *s(x, y)*: relative brightness distribution in the image of the light source,
- *aₖ*(*x, y)*: projection of *s*(*x, y*) in the camera plane (light source projection) during imaging of the disturbances on surface image (image shell) *k.*

The individual corrections ${δO}_{k}^{′} \left(x, y\right)$ in (10) were determined for *aₖ*(*x, y*)→0 with a punctiform light source. The use of an extensive light source can be regarded as the sum of all mutually independently luminous adjacent points. Accordingly, the individual corrections for an extensive light source can be formed from the convolution of ${δO}_{k}^{′} \left(x, y\right)$ with the light source projection *aₖ*(*x, y*): $C ′ \left(x, y\right) = O ′ \left(x, y\right) - {\sum }_{k = 1}^{K} {δO}_{k}^{′} \left(x, y\right) ∗ {a}_{k} \left(x, y\right)$ (12) with *aₖ*(*x, y)* as light source projection for the image shell *k.*

The convolution kernel *aₖ*(*x, y*) required according to (11) and (12) is calculated in advance from ray tracing of the interferometer configuration and the chosen light source form for each surface image k.

Figure 10 shows an example of a wavefront (Figure 10A) and amplitude (Figure 10B), which were measured with a large light source. The ring-shaped diffraction structures are distinctly blurred and damped in comparison with Figures 7A and 8A. Their correction is then effected by means of the sum of the individual corrections ${δO}_{k}^{′} \left(x, y\right)$ convolved according to (12).

### Application examples

The proposed method ascertains and reduces the disturbances originating from individual interferometer surfaces in the measured wavefront. The method concentrates on punctiform and filamentary disturbances on the surfaces, e.g. small dust grains, scratches, damage.

A further use could relate to undesired reflection images of the light source. Since each surface generates undesired specular reflection images of the light source despite antireflective coating, said images reaching the camera under certain circumstances, the proposed method could also play a part in damping said images. An exemplary method comprises:
1. a measurement sequence with a small light source (calibration measurement) for computationally determining the individual corrections ${δO}_{k}^{′} \left(x, y\right)$ originating from the individual surface images,
2. the regular measurements with an arbitrarily shaped and extensive light source with a relative brightness distribution *s(x, y),*
3. the computational correction of the measurements with an extensive light source by means of:
   a. forming the light source projections *aₖ*(*x, y*) for each of the K image shells according to equ. (11),
   b. calculating the individual corrections ${δO}_{k}^{′} \left(x, y\right) ∗ {a}_{k} \left(x, y\right)$ for each of the K image shells,
   c. subtracting the overall correction from the measured wavefront *O'*(*x, y*) according to equ. (12).

The method merely requires a calibration measurement with a small light source, which then provides the data sets required for the subsequent measurements with an arbitrarily extensive light source. As long as the beam path is not fundamentally changed and the artefacts on the surfaces remain unchanged, it is possible to use the data sets from the calibration measurement.

### Some advantages of the invention

The invention makes it possible to reduce coherent disturbances in the wavefront which originate from incomplete and/or contaminated interferometer surfaces.

The invention also makes it possible, if appropriate, to reduce undesired specular reflection images of the light source.

In this case, it is necessary to obtain the required calibration data sets from a measurement with a small light source, which are then applied to subsequent measurements with an arbitrarily shaped, extensive light source.

It is not necessary to expend additional outlay in respect of apparatus, such as e.g. the provision of an extensive light source or an upstream cavity.

In the series measurement, it is not necessary to expend an increased acquisition time, for instance by recording and imparting a plurality of wavefronts with the position of the light source being changed.

The noticeable outlay as a result of the proposed method consists in carrying out a calibration measurement and in lengthening the wavefront post-processing of the series measurement, which however usually does not have a significant impact.

## Claims

1. Measurement method for interferometrically determining a shape of an optical surface (112) of a test object (110) by means of a measurement system (100) comprising:
an illumination module (120) for producing an effective light source (130) in a light source plane (132) of the illumination module;
optical components comprising:
a collimator (210) for collimating the measurement light emitted by the effective light source (130);
a transparent reference element (220) disposed downstream of the collimator (210) and having a reference surface (222) facing the surface (112) of the test object (110), a cavity (230) being formed between the reference surface (222) and the surface (112) of the test object (110);
a beam splitter (240) arranged between the illumination module (120) and the collimator (210) in such a way that measurement light emitted by the effective light source (130) passes through to the collimator (210) or is reflected and measurement light reflected by the reference surface (222) and the surface (112) of the test object (110) is reflected in a superimposed manner in the direction of a detector (250) or is transmitted; the measurement method comprising
a measurement of a surface of the test object in order to ascertain a measured wavefront present in a detector surface of the detector, and
an evaluation of the wavefront using an evaluation unit, which has software loaded enabling the evaluation unit to carry out calculations in order to determine the shape of the optical surface,
**characterized in that** the evaluation comprises the following steps:
identifying interferometer surfaces, an interferometer surface being an optically effective surface of one of the optical components of the measurement system that is used at least once during a measurement;
determining surface-related coherent wavefront disturbances and assigning each of the wavefront disturbances to disturbing structures on one of the interferometer surfaces of the measurement system;
ascertaining a wavefront corrected in respect of coherent wavefront disturbances by surface-specific subtraction of the surface-related coherent wavefront disturbances from the measured wavefront;
evaluating the corrected wavefront,
wherein the method further comprises the following steps:
carrying out a calibration measurement using a quasi-punctiform effective light source;
determining the individual corrections of the wavefront that originate from the interferometer surface images on the basis of the calibration measurement;
carrying out a regular measurement with an extensive effective light source with a known relative brightness distribution;
computationally adapting the individual corrections of the wavefront to the known extensive effective light source in order to ascertain an overall wavefront correction;
subtracting the overall wavefront correction from the measured wavefront.

2. Measurement method according to Claim 1, **characterized in that** the following steps are carried out for each of the interferometer surfaces:
computational propagation of the ascertained wavefront according to amplitude and phase, such that the surface-related disturbing structures of optically effective surfaces appear sharp;
eliminating the disturbing structures from amplitude and phase of the respective focused interferometer surface image;
backpropagation in order to ascertain a wavefront corrected in respect of wavefront disturbances caused by the disturbing structures.

3. Measurement method according to Claim 1 or 2, **characterized in that** in order to eliminate images of the disturbing structures at least one algorithm from image processing is applied, in particular weighted median filters and/or the application of a convolution operator to the data fields of amplitude and phase.

4. Measurement method according to any of the preceding claims, **characterized in that** when ascertaining interferometer surface images for one or a plurality of interferometer surfaces a plurality of interferometer surface images are calculated.

5. Measurement method according to any of the preceding Claims **characterized by** a computation of correction values ascertained with a punctiform effective light source with a convolution function representing the blurring effect of the extensive light source.

6. Measurement system (100) for interferometrically determining a shape of an optical surface (112) of a test object (110), comprising:
an illumination module (120) for producing an effective light source (130) in a light source plane (132) of the illumination module;
optical components comprising:
a collimator (210) for collimating the measurement light emitted by the effective light source (130);
a transparent reference element (220) disposed downstream of the collimator (210) and having a reference surface (222) facing the surface (112) of the test object (110), a cavity (230) being formed between the reference surface (222) and the surface (112) of the test object (110);
a beam splitter (240) arranged between the illumination module (120) and the collimator (210) in such a way that measurement light emitted by the effective light source (130) passes through to the collimator (210) or is reflected and measurement light reflected by the reference surface (222) and the surface (112) of the test object (110) is reflected in a superimposed manner in the direction of a detector (250) of the measurement system or is transmitted;
**characterized in that** the measurement system comprises
a quasi-punctiform effective light source for carrying out a calibration measurement;
an extensive effective light source with a known relative brightness distribution for carrying out a regular measurement;
an evaluation unit; and wherein
the measuring system is configured for carrying out a measurement of the optical surface of the test object in order to ascertain a measured wavefront present in a detector surface of the detector and an evaluation of the wavefront in order to determine the shape of the optical surface in accordance with the measurement method according to any of Claims 1 to 5.

## Patentansprüche

1. Messverfahren zum interferometrischen Bestimmen einer Form einer optischen Oberfläche (112) eines Prüfobjekts (110) mittels eines Messsystems (100), das Folgendes umfasst:
ein Beleuchtungsmodul (120) zum Erzeugen einer effektiven Lichtquelle (130) in einer Lichtquellenebene (132) des Beleuchtungsmoduls;
optische Komponenten, die Folgendes umfassen:
einen Kollimator (210) zum Kollimieren des von der effektiven Lichtquelle (130) emittierten Messlichts;
ein lichtdurchlässiges Bezugselement (220), das ausgangsseitig des Kollimators (210) angeordnet ist und eine Bezugsoberfläche (222) aufweist, die der Oberfläche (112) des Prüfobjekts (110) zugewandt ist, wobei zwischen der Bezugsoberfläche (222) und der Oberfläche (112) des Prüfobjekts (110) ein Hohlraum (230) gebildet ist;
einen Strahlteiler (240), der zwischen dem Beleuchtungsmodul (120) und dem Kollimator (210) derart angeordnet ist, dass von der effektiven Lichtquelle (130) emittiertes Messlicht zum Kollimator (210) durchtritt oder reflektiert wird und von der Bezugsoberfläche (222) und der Oberfläche (112) des Prüfobjekts (110) reflektiertes Messlicht in Richtung eines Detektors (250) auf überlagerte Weise reflektiert oder durchgelassen wird; wobei das Messverfahren Folgendes umfasst:
Messen einer Oberfläche des Prüfobjekts, um eine gemessene Wellenfront zu ermitteln, die in einer Detektoroberfläche des Detektors vorhanden ist, und Auswerten der Wellenfront unter Verwendung einer Auswertungseinheit, die Software geladen hat, die es der Auswertungseinheit ermöglicht, Berechnungen durchzuführen, um die Form der optischen Oberfläche zu bestimmen,
**dadurch gekennzeichnet, dass** das Auswerten die folgenden Schritte umfasst:
Identifizieren von Interferometeroberflächen, wobei eine Interferometeroberfläche eine optisch wirksame Oberfläche einer der optischen Komponenten des Messsystems ist, die während einer Messung mindestens einmal verwendet wird;
Bestimmen von oberflächenbezogenen kohärenten Wellenfrontstörungen und Zuweisen jeder der Wellenfrontstörungen zu störenden Strukturen auf einer der Interferometeroberflächen des Messsystems;
Ermitteln einer Wellenfront, die hinsichtlich kohärenter Wellenfrontstörungen korrigiert ist, durch oberflächenspezifische Subtraktion der oberflächenbezogenen kohärenten Wellenfrontstörungen von der gemessenen Wellenfront;
Auswerten der korrigierten Wellenfront,
wobei das Verfahren ferner die folgenden Schritte umfasst:
Ausführen einer Kalibrierungsmessung unter Verwendung einer quasi-punktförmigen effektiven Lichtquelle;
Bestimmen der einzelnen Korrekturen der Wellenfront, die von den Interferometeroberflächenbildern ausgehen, auf der Grundlage der Kalibrierungsmessung;
Ausführen einer regulären Messung mit einer ausgedehnten effektiven Lichtquelle mit bekannter relativer Helligkeitsverteilung;
rechnerisches Anpassen der einzelnen Korrekturen der Wellenfront an die bekannte ausgedehnte effektive Lichtquelle, um eine Gesamtwellenfrontkorrektur zu ermitteln;
Subtrahieren der Gesamtwellenfrontkorrektur von der gemessenen Wellenfront.

2. Messverfahren nach Anspruch 1, **dadurch gekennzeichnet, dass** für jede der Interferometeroberflächen die folgenden Schritte durchgeführt werden:
rechnerisches Ausbreiten der ermittelten Wellenfront nach Amplitude und Phase in der Weise, dass die oberflächenbezogenen störenden Strukturen optisch wirksamer Oberflächen scharf erscheinen;
Beseitigen der störenden Strukturen aus Amplitude und Phase des jeweiligen fokussierten Interferometeroberflächenbilds;
Rückausbreiten, um eine Wellenfront zu ermitteln, die bezüglich Wellenfrontstörungen, die durch die störenden Strukturen verursacht werden, korrigiert ist.

3. Messverfahren nach Anspruch 1 oder 2, **dadurch gekennzeichnet, dass** zur Beseitigung von Bildern der störenden Strukturen mindestens ein Algorithmus aus der Bildverarbeitung, insbesondere gewichtete Medianfilter und/oder die Anwendung eines Faltungsoperators auf die Datenfelder von Amplitude und Phase, angewendet wird.

4. Messverfahren nach einem der vorhergehenden Ansprüche, **dadurch gekennzeichnet, dass** bei der Ermittlung von Interferometeroberflächenbildern für eine oder mehrere Interferometeroberflächen mehrere Interferometeroberflächenbilder berechnet werden.

5. Messverfahren nach einem der vorhergehenden Ansprüche, **gekennzeichnet durch** eine Berechnung von Korrekturwerten, die mit einer punktförmigen effektiven Lichtquelle mit einer Faltungsfunktion, die die Unschärfeerzeugungswirkung der ausgedehnten Lichtquelle darstellt, ermittelt werden.

6. Messsystem (100) zum interferometrischen Bestimmen einer Form einer optischen Oberfläche (112) eines Prüfobjekts (110), wobei das Messsystem Folgendes umfasst:
ein Beleuchtungsmodul (120) zum Erzeugen einer effektiven Lichtquelle (130) in einer Lichtquellenebene (132) des Beleuchtungsmoduls;
optische Komponenten, die Folgendes umfassen:
einen Kollimator (210) zum Kollimieren des von der effektiven Lichtquelle (130) emittierten Messlichts;
ein lichtdurchlässiges Bezugselement (220), das ausgangsseitig des Kollimators (210) angeordnet ist und eine Bezugsoberfläche (222) aufweist, die der Oberfläche (112) des Prüfobjekts (110) zugewandt ist, wobei zwischen der Bezugsoberfläche (222) und der Oberfläche (112) des Prüfobjekts (110) ein Hohlraum (230) gebildet ist;
einen Strahlteiler (240), der zwischen dem Beleuchtungsmodul (120) und dem Kollimator (210) derart angeordnet ist, dass von der effektiven Lichtquelle (130) emittiertes Messlicht zum Kollimator (210) durchtritt oder reflektiert wird und von der Bezugsoberfläche (222) und der Oberfläche (112) des Prüfobjekts (110) reflektiertes Messlicht in Richtung eines Detektors (250) auf überlagerte Weise reflektiert oder durchgelassen wird;
**dadurch gekennzeichnet, dass** das Messsystem Folgendes umfasst
eine quasi-punktförmige effektive Lichtquelle zum Ausführen einer Kalibrierungsmessung;
eine ausgedehnte effektive Lichtquelle mit bekannter relativer Helligkeitsverteilung zum Ausführen einer regulären Messung;
eine Auswertungseinheit; wobei
das Messsystem ausgebildet ist, eine Messung der optischen Oberfläche des Prüfobjekts, um eine in einer Detektorfläche des Detektors vorhandene gemessene Wellenfront zu ermitteln, und eine Auswertung der Wellenfront, um die Form der optischen Oberfläche zu ermitteln, gemäß dem Messverfahren nach einem der Ansprüche 1 bis 5 auszuführen.

## Revendications

1. Procédé de mesure destiné à déterminer par interférométrie une forme d'une surface optique (112) d'un objet à tester (110) au moyen d'un système de mesure (100) comprenant :
un module d'éclairage (120) servant à produire une source de lumière efficace (130) dans un plan de source de lumière (132) du module d'éclairage ;
des composants optiques comprenant :
un collimateur (210) servant à collimater la lumière de mesure émise par la source de lumière efficace (130) ;
un élément de référence transparent (220) disposé en aval du collimateur (210) et ayant une surface de référence (222) faisant face à la surface (112) de l'objet à tester (110), une cavité (230) étant formée entre la surface de référence (222) et la surface (112) de l'objet à tester (110) ;
un séparateur de faisceau (240) disposé entre le module d'éclairage (120) et le collimateur (210) de telle sorte que la lumière de mesure émise par la source de lumière efficace (130) traverse le collimateur (210) ou est réfléchie et la lumière de mesure réfléchie par la surface de référence (222) et la surface (112) de l'objet à tester (110) est réfléchie de manière superposée dans la direction d'un détecteur (250) ou est transmise ; le procédé de mesure comprenant
une mesure d'une surface de l'objet à tester afin de déterminer un front d'onde mesuré présent dans une surface de détecteur du détecteur, et
une évaluation du front d'onde au moyen d'une unité d'évaluation, qui dispose d'un logiciel chargé permettant à l'unité d'évaluation de réaliser des calculs afin de déterminer la forme de la surface optique,
**caractérisé en ce que** l'évaluation comprend les étapes suivantes :
identification de surfaces d'interféromètre, une surface d'interféromètre étant une surface optiquement efficace d'un des composants optiques du système de mesure qui est utilisée au moins une fois pendant une mesure ;
détermination de perturbations cohérentes de front d'onde liées à la surface et attribution de chacune des perturbations de front d'onde à des structures perturbatrices sur une des surfaces d'interféromètre du système de mesure ;
détermination d'un front d'onde corrigé des perturbations cohérentes de front d'onde par soustraction spécifique de la surface des perturbations cohérentes de front d'onde liées à la surface du front d'onde mesuré ;
évaluation du front d'onde corrigé,
le procédé comprenant en outre les étapes suivantes :
réalisation d'une mesure d'étalonnage au moyen d'une source de lumière efficace quasi ponctuelle ;
détermination des corrections individuelles du front d'onde qui proviennent des images de surface d'interféromètre sur la base de la mesure d'étalonnage ;
réalisation d'une mesure normale avec une source de lumière efficace étendue avec une distribution de luminosité relative connue ;
adaptation informatique des corrections individuelles du front d'onde à la source de lumière efficace étendue connue afin de déterminer une correction globale de front d'onde ;
soustraction de la correction globale de front d'onde du front d'onde mesuré.

2. Procédé de mesure selon la revendication 1, **caractérisé en ce que** les étapes suivantes sont réalisées pour chacune des surfaces d'interféromètre :
propagation informatique du front d'onde déterminé en fonction de l'amplitude et de la phase, de telle sorte que les structures perturbatrices liées à la surface des surfaces optiquement efficaces apparaissent nettes ;
élimination des structures perturbatrices de l'amplitude et de la phase de l'image de surface d'interféromètre mise au point respective ;
rétropropagation afin de déterminer un front d'onde corrigé de perturbations de front d'onde induites par les structures perturbatrices.

3. Procédé de mesure selon la revendication 1 ou 2, **caractérisé en ce que**, afin d'éliminer des images des structures perturbatrices, au moins un algorithme de traitement d'image est appliqué, en particulier des filtres médians pondérés, et/ou un opérateur de convolution est appliqué aux champs de données d'amplitude et de phase.

4. Procédé de mesure selon l'une quelconque des revendications précédentes, **caractérisé en ce que**, lors de la détermination d'images de surface d'interféromètre pour une surface ou une pluralité de surfaces d'interféromètre, une pluralité d'images de surface d'interféromètre sont calculées.

5. Procédé de mesure selon l'une quelconque des revendications précédentes, **caractérisé par** un calcul de valeurs de correction déterminées avec une source de lumière efficace ponctuelle avec une fonction de convolution représentant l'effet de floutage de la source de lumière étendue.

6. Système de mesure (100) destiné à déterminer par interférométrie une forme d'une surface optique (112) d'un objet à tester (110), comprenant :
un module d'éclairage (120) servant à produire une source de lumière efficace (130) dans un plan de source de lumière (132) du module d'éclairage ;
des composants optiques comprenant :
un collimateur (210) servant à collimater la lumière de mesure émise par la source de lumière efficace (130) ;
un élément de référence transparent (220) disposé en aval du collimateur (210) et ayant une surface de référence (222) faisant face à la surface (112) de l'objet à tester (110), une cavité (230) étant formée entre la surface de référence (222) et la surface (112) de l'objet à tester (110) ;
un séparateur de faisceau (240) disposé entre le module d'éclairage (120) et le collimateur (210) de telle sorte que la lumière de mesure émise par la source de lumière efficace (130) traverse le collimateur (210) ou est réfléchie et la lumière de mesure réfléchie par la surface de référence (222) et la surface (112) de l'objet à tester (110) est réfléchie de manière superposée dans la direction d'un détecteur (250) du système de mesure ou est transmise ;
**caractérisé en ce que** le système de mesure comprend une source de lumière efficace quasi ponctuelle servant à réaliser une mesure d'étalonnage ;
une source de lumière efficace étendue avec une distribution de luminosité relative connue servant à réaliser une mesure normale ;
une unité d'évaluation ; et
le système de mesure étant conçu pour réaliser une mesure de la surface optique de l'objet à tester afin de déterminer un front d'onde mesuré présent dans une surface de détecteur du détecteur et une évaluation du front d'onde afin de déterminer la forme de la surface optique suivant le procédé de mesure selon l'une quelconque des revendications 1 à 5.
